# EUROPEAN PATENT APPLICATION

(11) **EP 4 814 037 A1**
(43) Date of publication of application: **30.09.2026**
(21) Application number: 24908069.8
(22) Date of filing: 18.12.2024
(51) Int. Cl.: C08G 73/10, C08J 5/18, B32B 15/088, H05K 1/03

(54) **POLYAMIC ACID COMPOSITION, AND POLYIMIDE FILM AND METAL LAMINATED PLATE USING SAME**

(30) Priority: 19.12.2023 KR 20230185840
(71) Applicant: Doosan Corporation, Seoul 04563 (KR)
(72) Inventor: KIM, Jaemee, Yongin-si, Gyeonggi-do 16858 (KR); JUNG, Yoonho, Yongin-si, Gyeonggi-do 16858 (KR); LEE, Sanghwan, Yongin-si, Gyeonggi-do 16858 (KR); KIM, Sungjin, Yongin-si, Gyeonggi-do 16858 (KR)
(74) Representative: Isarpatent
(86) International application number: PCT/KR2024/020620
(87) International publication number: WO 2025/135786

(57) **Abstract**

The present invention provides: a polyamic acid composition comprising at least one diamine, at least one acid dianhydride, and an organic solvent, wherein the diamine further includes a diamine containing an alkyl group having 4 or more carbon atoms in a main chain or side chain thereof; and a metal laminated plate comprising a polyimide film formed by imidizing the polyamic acid composition. In the present invention, by including a diamine monomer containing an alkyl group having a predetermined number of carbon atoms, excellent processability can be exhibited through low viscosity and, at the same time, low dielectric loss, high adhesive strength, and excellent dimensional stability can be secured.

## Description

### Technical Field

The present invention relates to a polyamic acid composition comprising a diamine monomer containing an alkyl group having a predetermined carbon number, a polyimide film and a metal clad laminate which are formed from the composition to simultaneously secure low dielectric loss, high adhesion strength and excellent dimensional stability.

### Background Art

Flexible copper clad laminates (Flexible Copper Clad Laminate, FCCL) are mainly used as a substrate for a flexible printed circuit board (FPCB), and others are used in surface heating element electromagnetic wave shielding materials, flat cables, packaging materials, and the like. Recently, as electronic devices using a printed circuit board have become gradually smaller, dense, and highly efficient, the use of flexible copper clad laminates has been further increased.

The flexible copper clad laminates generally include a polyimide-based insulating layer and a copper foil layer. The flexible copper clad laminates may be classified into flexible copper clad laminates prepared by laminating a copper foil layer on a polyimide film, flexible copper clad laminates prepared by laminating a polyimide layer on a copper foil layer, and the like according to a manufacturing method thereof. That is, the flexible copper clad laminates include a flexible copper clad laminate prepared by an adhesive method and a flexible copper clad laminate prepared by a cast method.

The flexible copper clad laminates prepared by the adhesive method are formed by attaching a copper foil layer to a polyimide film by a separate adhesive, for example, an epoxy adhesive. The adhesive method of the flexible copper clad laminates dominates various physical properties such as heat resistance, chemical resistance, flame retardancy, and electrical properties of the final flexible copper clad laminates due to the properties of the adhesive or the adhesive film to be used. Therefore, properties such as excellent flexibility and heat resistance of the polyimide resin are not sufficiently exhibited.

Meanwhile, in the case of the flexible copper clad laminates prepared by the cast method, instead of not using an adhesive, a polyimide resin layer is formed on the copper foil layer by applying a polyimide varnish on the copper foil layer and then heat-treating the polyimide varnish under appropriate conditions. However, since the adhesive performance of the polyimide layer and the copper foil is poor in the flexible copper clad laminates by the cast method, a separate thermoplastic polyimide for securing adhesion between the insulating layer and the copper foil is essentially used, and thus, production costs are increased and production efficiency is reduced. In addition, problems such as structural deformation and interlayer separation of the flexible copper clad laminate and the printed circuit board may occur due to the introduction of a multilayered insulating layer.

### Disclosure of Invention

### Technical Problem

The present invention has been made in an effort to solve the above-mentioned problems, and it is an object of the present invention to provide a novel polyamic acid composition, a polyimide film formed from the composition, and a metal clad laminate including a polyimide insulating layer, which can simultaneously secure high adhesion, low dielectric loss, excellent flexibility, and dimensional stability even if a separate thermoplastic polyimide or an adhesive is not contained through modification of components of the polyamic acid composition constituting the polyimide and adjustment of the content thereof.

Other purposes and advantages of the present invention will be clarified by following detailed description and claims.

### Solution to Problem

To achieve the above objectives, the present invention provides a polyamic acid composition comprising: at least one diamine; at least one acid anhydride; and an organic solvent; wherein the diamine further comprises a diamine containing an alkyl group having 4 or more carbon atoms in a main chain or a side chain.

In an embodiment of the present invention, the alkyl group may be a linear aliphatic alkyl group having 4 to 40 carbon atoms.

In an embodiment of the present invention, the diamine containing the alkyl group having 4 or more carbon atoms may be included in an amount of more than 0 mol % and 30 mol % or less, based on 100 mol % of the total amount of the diamine.

In an embodiment of the present invention, the diamine may further comprise a diamine containing one or more ester groups and an aromatic ring in a main chain.

In an embodiment of the present invention, the diamine containing the ester group and the aromatic ring may be included in an amount of 5 to 30 mol %, based on 100 mol % of the total amount of the diamine.

In an embodiment of the present invention, a molar ratio of the diamine containing the alkyl group having 4 or more carbon atoms and the diamine containing the ester group and the aromatic ring may be in a range of 1:1.1 to 1:5 mol %.

In an embodiment of the present invention, the at least one diamine may comprise at least one selected from the group consisting of a fluorinated aromatic diamine; a sulfone-based aromatic diamine; a hydroxy-based aromatic diamine; an ether-based aromatic diamine; a non-fluorinated aromatic diamine; and an alicyclic diamine.

In an embodiment of the present invention, the at least one acid anhydride may comprise at least one selected from the group consisting of a fluorinated aromatic acid anhydride, a non-fluorinated aromatic acid anhydride, a sulfone-based aromatic acid anhydride, and an alicyclic acid anhydride.

In an embodiment of the present invention, the polyamic acid composition may further comprise an inorganic filler.

In an embodiment of the present invention, the polyamic acid composition may have a viscosity of 10,000 to 50,000 cps at 25° C.

Further, the present invention provides a polyimide film formed by imidizing the polyamic acid composition as described above.

Furthermore, the present invention provides a metal clad laminate comprising: at least one metal layer; and a polyimide insulating layer formed on one surface of the metal layer or between the metal layers, and formed by imidizing the polyamic acid composition as described above.

In an embodiment of the present invention, the polyimide insulating layer may be formed by applying, drying, and imidizing the polyamic acid composition on the metal layer, and the metal clad laminate may not comprise a thermoplastic polyimide or an adhesive.

In an embodiment of the present invention, the metal layer may be selected from copper, aluminum, iron, silver, palladium, nickel, chromium, molybdenum, tungsten, or an alloy thereof.

In an embodiment of the present invention, the polyimide insulating layer may have a thickness of 1 to 50 µm.

In addition, the present invention provides a printed circuit board comprising the polyimide film, specifically a flexible printed circuit board (FPCB).

### EFFECTS OF THE INVENTION

According to an embodiment of the present invention, by using a diamine containing an alkyl group having a predetermined carbon number as one component of a polyamic acid composition constituting a polyimide, high adhesion, low dielectric loss, excellent flexibility, and dimensional stability may be simultaneously achieved.

In addition, the use of a separate thermoplastic polyimide or an adhesive may be excluded, thereby reducing production costs and improving production efficiency. In addition, due to the low viscosity of the polyamic acid composition, a simplified manufacturing process and a reduced process costs may be achieved.

In addition, in the present invention, since a metal clad laminate may be manufactured by simply coating, drying, and imidizing the polyamic acid composition on a metal layer, the possibility of a issue such as a flexible metal clad laminate (FCCL) and a flexible printed circuit board (FPCB) deformation, and interlayer delamination occurring when a multi-layered insulating layer is applied may be prevented, thereby securing high reliability.

Accordingly, the polyamic acid composition according to the present invention may be usefully used as a low dielectric flexible metal clad laminate (FCCL) or a flexible printed circuit board (FPCB) material for a 5G mobile device, specifically an insulating layer material, and may be applied to various other technical fields without limitation.

Effects according to the present invention are not limited by the description exemplified above, and more diverse effects are included in the present specification.

### BRIEF DESCRIPTION OF DRAWINGS

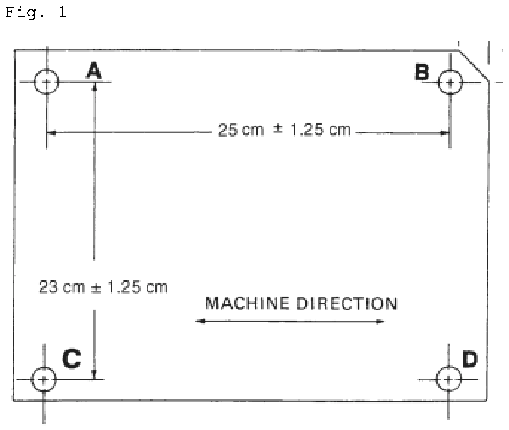

FIG. 1 is a diagram illustrating a method of measuring dimensional stability according to an embodiment of the present invention.

### DETAILED DESCRIPTION OF THE INVENTION

Hereinafter, the present invention will be described in detail. The embodiments of the present invention are provided to more fully describe the present invention to those skilled in the art, and the following embodiments may be modified into various other forms, and the scope of the present invention is not limited to the following embodiments. Here, the same reference numerals refer to the same structure throughout this specification.

Unless otherwise defined, all terms used in the present specification (including technical and scientific terms) may be used with meanings that may be commonly understood by those skilled in the art. In addition, the terms defined in the commonly used dictionaries are not ideally or excessively interpreted, unless they are specifically defined clearly.

In addition, throughout the specification, when a part is said to "include" an element, it means that it may further include another element, not excluding other elements, unless otherwise stated. In addition, throughout the specification, "above" or "on" means not only the case where it is located above or below a target part but also the case where there is another part in the middle thereof and does not necessarily mean the upward direction of gravity.

### <Polyamic acid composition>

An embodiment of the present invention is a polyamic acid composition for forming a polyimide precursor [e.g., poly(amic acid), PAA] polymer, and specifically, a polyimide precursor solution for forming an insulating layer of a common flexible metal clad laminate (FCCL) or a flexible printed circuit board (FPCB) known in the art.

In one embodiment, the polyamic acid composition includes at least one diamine; at least one diacid anhydride; and an organic solvent, and wherein the diamine further includes a diamine containing an alkyl group having 4 or more carbon atoms in a main chain or a side chain. If necessary, the polyamic acid composition may further include at least one common additive known in the art.

The alkyl group included in the diamine monomer may be an aliphatic alkyl group having a carbon number of at least 4 or more, and specifically, an aliphatic alkyl group having a linear structure. Such an alkyl group inhibits charge transfer between polymer chains and induces generation of pores, thereby leading to a decrease in dielectric loss of the polyimide resin itself. Accordingly, the present invention can be applied as a low dielectric material capable of increasing signal transmission speed and reducing transmission loss.

In addition, the alkyl group included in the diamine monomer is relatively flexible and has a high degree of freedom compared to conventional rigid aromatic or alicyclic moieties. Accordingly, by formation of pores between polymer chains, excellent flexibility and adhesive properties of the polyimide resin itself can be exhibited. In particular, by including a predetermined aliphatic functional group, adhesive properties with a substrate can be significantly improved compared to conventional phenyl group or ether group-containing diamine. Accordingly, even if a single polyimide insulating layer is provided without using a separate adhesive or a thermoplastic polyimide, it is possible to provide a flexible metal clad laminate and a flexible printed circuit board having high adhesive strength, flexibility, and high reliability.

The diamine containing an alkyl group included as one component of the reactants of the polyamic acid composition according to the present invention is not particularly limited as long as it contains a diamine functional group in the molecule and contains an alkyl group having a predetermined carbon number in the main chain or side chain of the molecule.

In this case, when the alkyl group has a carbon number of 3 or less, the dielectric loss reduction effect is insignificant, whereas when the carbon number is too large, processability and handling properties are deteriorated due to an increase in viscosity. Therefore, the carbon number of the alkyl group included in the diamine is required to be adjusted within a predetermined range. Accordingly, in the present invention, an aliphatic alkyl group having a carbon number of at least 4 is used, and for example, a diamine having a linear aliphatic alkyl group having a carbon number of 4 to 40, specifically 5 to 38, and more specifically 6 to 36 may preferably be used.

In one embodiment, the diamine containing the alkyl group having 4 or more carbon atoms may be more specifically represented by compounds represented by the following Chemical Formulas 1 to 3. However, the present invention is not limited thereto. 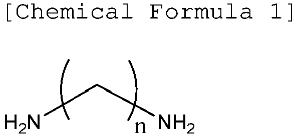 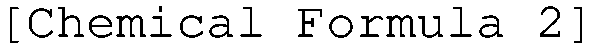 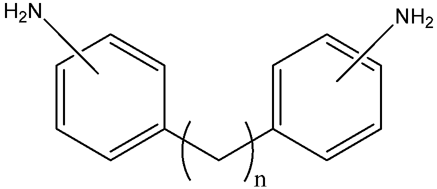 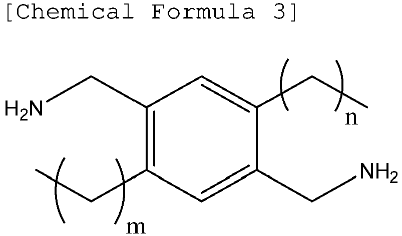 wherein, in Chemical Formulas 1 to 3,
n and m may be the same as or different from each other, and may each independently be an integer of 4 to 40. Further, although not separately indicated in the above Chemical Formulas, a compound substituted with one or more substituents selected from the group consisting of halogen, -CF₃, -OH, and amine groups known in the art in Chemical Formulas 1 to 3 described above are also included in the scope of the present invention.

Non-limiting examples of the diamine containing an alkyl group having 4 or more carbon atoms may include tetramethylenediamine, hexamethylenediamine, decamethylenediamine, dodecamethylenediamine, Priamine, and the like.

The content of the diamine containing an alkyl group having 4 or more carbon atoms according to the present invention is not particularly limited, and may be appropriately adjusted within the content range known in the art in consideration of the dielectric loss reduction effect. For example, the diamine containing an alkyl group having 4 or more carbon atoms may each be included in an amount of more than 0 mol % and 30 mol % or less based on 100 mol % of the diamine, and specifically, may be in a range of 5 to 20 mol %. When the content of the alkyl group-containing diamine is in the above-described range, a polyamic acid resin having high flexibility, high adhesive strength, and a high molecular weight may be formed while exhibiting a desired dielectric loss reduction effect, and when the content is outside the above-described range, dimensional stability may be degraded.

The polyamic acid composition according to the present invention includes at least one diamine (a) known in the art; and at least one diacid anhydride (b) known in the art.

The diamine (a) component is not limited as long as it is a compound having a diamine structure in the molecule, and for example, an aromatic, alicyclic, or aliphatic compound having a diamine structure, or a combination thereof may be used. As a specific example, a fluorinated aromatic diamine having a fluorine substituent introduced thereto, a sulfone-based aromatic diamine, a hydroxy-based aromatic diamine, an ether-based aromatic diamine, a non-fluorinated aromatic diamine, an alicyclic diamine may be used alone or in combination of two or more thereof.

Non-limiting examples of the diamine monomer (a) include: p-phenylenediamine (PDA), oxydianiline (ODA), 2,2'-bis(trifluoromethyl)-4,4'-diaminobiphenyl (2,2'-TFDB), 2,2'-bis(trifluoromethyl)-4,3'-diaminobiphenyl, 2,2'-bis(trifluoromethyl)-5,5'-diaminobiphenyl, 2,2'-bis(trifluoromethyl)-4,4'-diaminodiphenyl ether (6-FODA), bis(aminohydroxy phenyl)hexafluoropropane (DBOH), bis(aminophenoxy phenyl)hexafluoropropane (4BDAF), bis(aminophenoxy phenylpropane) (6HMDA), bis(aminophenoxy diphenylsulfone) (DBSDA), bis(4-aminophenyl)sulfone (4,4'-DDS), bis(3-aminophenyl)sulfone (3,3'-DDS), sulfonyldiphthalic anhydride (SO2DPA), 4,4'-oxydianiline (4,4'-ODA), or a mixture of one or two or more thereof may be used.

As an example, the fluorinated first diamine may use 2,2'-bis(trifluoromethyl)-4,4'-diaminobiphenyl (2,2'-TFDB), 1,4-bis(4-amino-2-trifluoromethylphenoxy)benzene (6-FAPB), which can induce linear polymerization. In addition, the sulfone-based second diamine may use bis(4-aminophenyl)sulfone (4,4'-DDS) or 3,3'-DDS. In addition, the hydroxy-based third diamine may use 2,2-bis(3-amino-4-hydroxyphenyl)hexafluoropropane (BIS-AP-AF). In addition, the ether-based fourth diamine may use 2,2'-bis(trifluoromethyl)-4,4'-diaminodiphenyl ether (6-FODA), or oxydianiline (ODA). In addition, the non-fluorinated fifth diamine may use 2,2-bis(3-amino-4-methylphenyl)-hexafluoropropane (BIS-AT-AF), m-tolidine, or p-phenylenediamine (p-PDA). In addition, as a non-limiting example of the alicyclic diamine usable, 2,2-bis(3-amino-4-hydroxycyclohexyl)hexafluoropropane, 3,3'-dimethyl-4,4'-diaminodicyclohexylmethane (MACM), 4,4'-methylenebicyclohexylamine (PACM), 1,3-bis(aminomethyl)cyclohexane (1,3-BAC), 1,4-bis(aminomethyl)cyclohexane (1,4-BAC), cis-1,2-cyclohexanedimethanamine, trans-1,2-cyclohexanedimethanamine, 1,4-cyclohexyldiamine (CHDA), bis(4-aminocyclohexyl) ether, or a mixture thereof may be used.

The content of at least one diamine monomer (a) selected from the fluorinated aromatic diamine, the sulfone-based aromatic diamine, the hydroxy-based aromatic diamine, the ether-based aromatic diamine, the non-fluorinated aromatic diamine, and the alicyclic diamine is not particularly limited, and may be 0 to 100 mol %, specifically 10 to 90 mol %, and more specifically 20 to 80 mol %, based on 100 mol % of the total diamine. However, the content of at least one of the aromatic diamine and/or the alicyclic diamine is such that the total amount of the diamine composition is 100 mol %.

In the diamine monomer (a), the mixing ratio of the non-fluorinated aromatic diamine and the ether-based diamine may be 0 to 100 mol % : 100 to 0 mol %, specifically 10 to 90 mol % : 90 to 10 mol %, based on 100 mol % of the total diamine, and may be appropriately adjusted within a range known in the art.

In one embodiment, the mixing ratio of the non-fluorinated aromatic diamine, the ether-based diamine, and the diamine containing an alkyl group having 4 or more carbon atoms may be 40 to 65 : 5 to 30 : more than 0 to 30 mol %, based on 100 mol % of the total diamine, and more specifically, may be 50 to 65 : 10 to 25 : 5 to 20 mol %. When the content ratio of the non-fluorinated aromatic diamine, the ether-based diamine, and the diamine containing an alkyl group having 4 or more carbon atoms falls within the above-described range, a polyamic acid resin having desired high thermal properties and high adhesive strength may be formed.

Meanwhile, in the present invention, the diamine may further include a diamine containing at least one ester group and an aromatic ring in the main chain as a component of the diamine.

When such an alkyl group-containing diamine and acid dianhydride are used in combination with a diamine containing an ester group and an aromatic ring, a synergistic effect may be exhibited in terms of the dielectric loss reduction effect of the polyimide resin itself. Non-limiting examples of the diamine containing an ester group and an aromatic ring which may be used include 4-aminophenyl-4-aminobenzoate (APAB), 1,4-phenylene-di-4-aminobenzoate (ABHQ), or a mixture thereof.

The content of the diamine containing an ester group and an aromatic ring according to the present invention is not particularly limited, and may be appropriately adjusted within the content range known in the art in consideration of the effect of improving dimensional stability. For example, the diamine containing an ester group and an aromatic ring may be included in the range of 5 to 30 mol %, and specifically, may be included in the range of 10 to 20 mol %, based on 100 mol % of the diamine.

In addition, the diamine containing a carbon number of 4 or more alkyl groups and the diamine containing an ester group and an aromatic ring are preferably adjusted to a predetermined range in consideration of the effect of reducing dielectric loss. For example, the mixing ratio of the diamine containing a carbon number of 4 or more alkyl groups and the diamine containing an ester group and an aromatic ring may be in the range of 1:1.1 to 1:5 mol %, and specifically, may be in the range of 1:1.2 to 1:4 mol %.

The acid dianhydride (b) monomer included in the polyamic acid composition of the present invention is not limited as long as it is a compound having an intramolecular dianhydride structure, and for example, an aromatic, alicyclic, aliphatic compound having an acid dianhydride structure, or a combination thereof may be used. As a specific example, a fluorinated aromatic acid dianhydride having a fluorine substituent introduced thereto, a non-fluorinated aromatic acid dianhydride, a sulfone-based aromatic acid dianhydride, and an alicyclic acid dianhydride may be used alone or in a mixture of two or more thereof.

The fluorinated acid dianhydride monomer is not particularly limited as long as it is an aromatic dianhydride having a fluorine substituent introduced thereto. Non-limiting examples of the fluorinated acid dianhydride monomer may be 2,2-bis(3,4-dicarboxyphenyl)hexafluoropropane dianhydride (6-FDA), 4-(trifluoromethyl) pyromellitic dianhydride (4-TFPMDA), or a mixture thereof.

In addition, the non-fluorinated acid dianhydride monomer is not particularly limited as long as it is a non-fluorinated aromatic acid dianhydride having no fluorine substituent introduced thereto. Non-limiting examples of the non-fluorinated third dianhydride monomer may include pyromellitic dianhydride (PMDA), 3,3',4,4'-biphenyltetracarboxylic acid dianhydride (BPDA), benzophenonetetracarboxylic acid dianhydride (BTDA), oxydiphthalic acid dianhydride (ODPA), 4,4-(4,4-Isopropylidenediphenoxy)bis(phthalic anhydride) (BPADA), bis(3,4-dicarboxyphenyl)dimethylsilanedianhydride (SiDA), or a mixture thereof.

In addition, the sulfone-based acid dianhydride monomer is not particularly limited as long as it is a dianhydride having a sulfone group introduced thereto, and may be, for example, 3,3',4,4'-diphenylsulfonetetracarboxylic dianhydride (DSDA).

In addition, the alicyclic acid dianhydride is not particularly limited as long as it is a compound having a alicyclic ring other than an aromatic ring in the compound and having an acid dianhydride structure. Non-limiting examples of the alicyclic acid dianhydride may include cyclobutanetetracarboxylic acid dianhydride (CBDA), 1,2,3,4-cyclopentanetetracarboxylic acid dianhydride (CPDA), bicyclo[2,2,2]-7-octene-2,3,5,6-tetracarboxylic acid dianhydride (BCDA), 4-(2,5-dioxotetrahydrofuran-3-yl)-1,2,3,4-tetrahydronaphthalene-1,2-dicarboxylic acid dianhydride (TDA), 1,1'-bicyclohexane-3,3',4,4'-tetracarboxylic acid dianhydride (H-BPDA), 1,2,4,5-cyclohexanetetracarboxylic acid dianhydride (H-PMDA), cyclopentanone bis-spironorbornane (cpODA), Bicyclo[2.2.2]octane-2,3,5,6-tetracarboxylic 2,3:5,6-Dianhydride (7CI,8CI), or a mixture thereof.

The content of the acid dianhydride monomer (b) selected from the fluorinated aromatic acid dianhydride, the non-fluorinated aromatic acid dianhydride, the sulfone-based aromatic acid dianhydride, and the alicyclic acid dianhydride is not particularly limited, and may be 0 to 100 mol %, specifically 10 to 90 mol %, and more specifically 20 to 80 mol %, based on 100 mol % of the total dianhydride. However, the content of at least one of the aromatic acid dianhydride to the alicyclic acid dianhydride is contained to satisfy 100 mol % of the total acid dianhydride.

In the polyamic acid composition of the present invention, the ratio (a/b) of the moles of the diamine component (a) to the moles of the acid dianhydride component (b) may be 0.7 to 1.3, preferably 0.8 to 1.2, and more preferably 0.9 to 1.1 , in terms of molar ratio.

In addition, the polyamic acid composition of the present invention may use an organic solvent known in the art as a solvent for the solution polymerization of the above-described monomers without limitation. For example, one or more polar solvents selected from m-cresol, N-methyl-2-pyrrolidone (NMP), dimethylformamide (DMF), dimethylacetamide (DMAc), dimethylsulfoxide (DMSO), acetone, diethyl acetate, and dimethyl phthalate (DMP) may be used. In addition, a low boiling point solvent such as tetrahydrofuran (THF), chloroform, or a solvent such as γ-butyrolactone may be used. Here, the content of the solvent (the first solvent for polymerization) is not particularly limited, but may be preferably 50 to 95 wt %, more preferably 70 to 90 wt % based on the weight of the total polyamic acid composition in order to obtain a suitable molecular weight and viscosity of the polyamic acid composition (polyamic acid solution).

If necessary, the polyamic acid composition of the present invention may further include conventional inorganic fillers known in the art in consideration of dimensional stability, cte improvement, mechanical properties, and reduction of stress.

Non-limiting examples of the inorganic fillers include silica, calcium carbonate, magnesium carbonate, alumina, magnesia, clay, talc, calcium silicate, titanium oxide, antimony oxide, glass fiber, aluminum borate, barium titanate, strontium titanate, calcium titanate, magnesium titanate, bismuth titanate, titanium oxide, barium zirconate, calcium zirconate, boron nitride, silicon nitride, talc, mica, and the like. At this time, it is preferable to include at least one selected from the group consisting of talc, mica, silica, and calcium carbonate. In addition, the amount of the inorganic filler is not particularly limited, and may be appropriately adjusted in consideration of the above-described bending properties, mechanical properties, and the like.

In addition, the average particle diameter of the inorganic filler may be appropriately adjusted within a general range known in the art, and may be, for example, 0.1 to 10 µm. When the average particle diameter of the inorganic filler is less than 0.1 µm, the surface area of the inorganic filler may be increased, and thus dispersibility in the polyimide precursor solution may not be good, and when the average particle diameter exceeds 10 µm, agglomerated inorganic filler particles may appear in the polyimide layer, thereby deteriorating appearance uniformity.

In the present invention, the aforementioned diamine, the acid dianhydride, and the alkyl group-containing diamine may be introduced into a solvent and then reacted to prepare a polyamic acid composition. For example, the polyamic acid composition may be formed by including at least one diamine component, at least one acid dianhydride, and an alkyl group-containing diamine, and by using the diamine (a) and the acid dianhydride (b) in an equivalent ratio of about 1:1.

The polyamic acid composition configured as described above may have a viscosity (25°C) of about 10,000 to 50,000 cps, specifically 15,000 to 38,000 cps. When the viscosity of the polyamic acid composition falls within the aforementioned range, it is easy to control the thickness during coating of the polyamic acid composition, and the coating surface may be uniformly formed.

If necessary, the polyamic acid composition according to the present invention may further include one or more conventional additives known in the art within a range not hindering the objects and effects of the above-described invention. Specific examples of the additives usable include plasticizers, antioxidants, flame retardants, dispersants, viscosity modifiers, leveling agents, catalysts, dehydrating agents, thermal conductivity improvers, electrical properties improvers, wear resistance improvers, tracking resistance improvers, reinforcing agents, acid resistance improvers, dyes, and the like. These may be used alone or in combination of two or more thereof.

### <Polyimide film>

Another embodiment of the present invention is a polyimide film prepared from the aforementioned polyamic acid composition, and specifically, is a polyimide film imidized by allowing a polyamic acid resin solution formed by solution-polymerizing a polyamic acid composition including an alkyl group-containing diamine to be closed-looped and dewatered at a high temperature.

In one embodiment, the polyimide film includes a polyimide having a weight average molecular weight (Mw) of 20,000 g/mol to 100,000 g/mol. More specifically, the polyimide resin may have a weight average molecular weight (Mw) of 40,000 to 60,000 g/mol.

The polyimide film according to the present invention may be prepared by a conventional method known in the art, and for example, may be prepared by coating, drying, and imidizing a polyamic acid composition on a substrate.

The method of coating the polyamic acid composition on a substrate is not particularly limited, and a conventional coating method known in the art may be used without limitation. For example, various methods such as casting, dip coating, die coating, roll coating, slot die coating, comma coating, or a mixture thereof may be used.

In this case, a conventional substrate known in the art may be used as the substrate, and preferably, a metal substrate or a heat-resistant polymer substrate capable of withstanding a curing temperature of 100 °C or higher may be used. In addition, the drying and imidization processes may be appropriately performed under conventional conditions known in the art. For example, the drying may be performed at 100 to 200 °C, and the imidization process may be performed at 300 to 400 °C for 5 to 60 minutes.

The thickness of the polyimide film prepared as described above is not particularly limited, and may be appropriately adjusted within a range known in the art. For example, the thickness may be 5 to 100 µm, preferably 7 to 80 µm, and more preferably 10 to 50 µm in order to secure excellent low dielectric properties, mechanical properties, and dimensional stability.

### <Metal clad laminate>

Another embodiment of the present invention is a metal clad laminate, and specifically, a flexible metal clad laminate including a polyimide insulating layer or a polyimide film formed by imidizing the aforementioned polyamic acid composition.

The metal clad laminate may have a cross-sectional or double-sided structure in which a metal layer is disposed on one surface or both surfaces of the insulating layer based on the insulating layer. More specifically, the metal clad laminate includes at least one metal layer; and a polyimide insulating layer disposed on one surface of the metal layer or between the metal layers, wherein the polyimide insulating layer is formed by imidizing a polyamic acid composition including a predetermined alkyl group-containing diamine and an acid dianhydride.

The metal layer may be a metal or an alloy known in the art that exhibits conductivity and ductility, and for example, may be selected from copper, aluminum, iron, silver, palladium, nickel, chromium, molybdenum, tungsten, or an alloy thereof. Preferably, the metal layer may be a copper foil. Examples of the copper foil that may be used include CFL (TZA_B, HFZ_B), Mitsui (HSVSP, MLS-G), Nikko (RTCHP), Furukawa, ILSIN, and the like. In addition, a rolled copper foil or an electrolytic copper foil may be used as the copper foil, and a copper foil treated with rust prevention may be used to prevent the surface from being oxidized and corroded.

In addition, the metal layer may have a surface roughness (Rz) formed on a surface in contact with the polyimide insulating layer. In this case, the surface roughness (Rz) range is not particularly limited, and for example, may be 0.6 to 3.0 µm. The thickness of the metal layer is not particularly limited, but may be less than 5 µm, and preferably 1 to 3 µm in consideration of the thickness and mechanical characteristics of the metal clad laminate.

The thickness of the polyimide insulating layer is not particularly limited, and may be appropriately adjusted within a range known in the art. For example, the thickness may be 1 to 50 µm, specifically 5 to 50 µm, and more specifically 7 to 50 µm. The other configurations of the polyimide insulating layer are the same as those described above, and thus a separate description thereof will be omitted.

Meanwhile, the metal clad laminate according to the present invention is differentiated from a conventional metal clad laminate in that a polyimide insulating layer is formed by coating, drying, and imidizing a polyamic acid composition on a metal layer, and a thermoplastic polyimide or an adhesive is not included. In particular, the metal clad laminate of the present invention may have a low dielectric loss ratio (Df) due to a reduction in the dielectric loss of the polyimide itself, and may exhibit excellent flexibility and high adhesion force even if the polyimide and/or the adhesive is not included.

In one specific example, the metal clad laminate may have a dielectric loss (Df) measured at a frequency of 10 GHz or more and 28 GHz or less of 0.007 or less, a adhesion strength of the polyimide insulating layer to the metal layer according to IPC-TM-650 2.4.9 of 0.7 kgf/cm or more, a dimensional change rate in the MD direction according to IPC-TM-650 2.2.4 of ±0.2% or less, and a dimensional change rate in the TD direction of ±0.2% or less. More specifically, the dielectric loss (Df) measured at a frequency of 10 GHz or more and 28 GHz or less of 0.0020 to 0.0069 and may be 0.0022 to 0.0040. In addition, the adhesion stength of the polyimide insulating layer to the metal layer according to IPC-TM-650 2.4.9 of 0.7 to 1.5 kgf/cm, a dimensional change rate in the MD direction according to IPC-TM-650 2.2.4 of ±0.15% or less, and a dimensional change rate in the TD direction of ±0.15% or less.

### <Printed circuit board>

Another embodiment of the present invention is a printed circuit board, specifically a flexible printed circuit board (FPCB) including a polyimide insulating layer or a polyimide film formed by imidizing the aforementioned polyamic acid composition.

The printed circuit board may be a single-layer or multilayer printed circuit board including at least one metal circuit pattern.

The printed circuit board according to the present invention may be manufactured by a method known in the art. Specifically, the printed circuit board may be manufactured by forming a through-hole in the at least one metal clad laminate, for example, a copper foil laminate, and performing through-hole plating, and then etching the copper foil to form a circuit.

Since the aforementioned polyamic acid composition of the present invention, the polyimide film using the same, the metal clad laminate, and the printed circuit board are manufactured by including the aforementioned diamine/dianhydride having a predetermined carbon number alkyl group, the dielectric loss (Df) is low, and may exhibit high adhesion force and excellent flexibility and dimensional stability even if the polyimide and/or the adhesive is not included. Accordingly, the metal clad laminate and the printed circuit board of the present invention may be usefully used as a metal clad laminate and/or a printed circuit board applied to a mobile communication device that handles a highfrequency signal of 1 GHz or more, a network-related electronic device such as a base station device thereof, a server, a router, and various electronic electronic devices such as a large computer, and particularly, preferably applied to a low dielectric metal clad laminate (FCCL) for a 5G mobile device. The present invention may be applied to various technical fields requiring low dielectric loss ratio, high adhesion strength, excellent flexibility, and dimensional stability.

Hereinafter, the present invention will be described in detail through examples. However, the following examples are only to illustrate the present invention, and the present invention is not limited by the following examples.

### [Examples 1 to 5]

A polyamic acid composition was prepared using the composition including the diamine and the dianhydride described in Table 1 below. Specifically, as the diamine component, PDA (p-phenylenediamine), m-TB (m-Tolidine), ODA (4,4'-Diaminodiphenylether), APAB (4-Aminophenyl-4-aminobenzoate), ABHQ (1,4-Phenylene-di-4-aminobenzoate), TrA (Trimethylenediamine, n=3), TeA (Tetramethylenediamine, n=4), and PA (Priamine 1075, n=36) were used, and as the acid dianhydride component, BPDA (3,3',4,4'-Biphenyltetracarboxylic dianhydride) was used.

The polyamic acid composition was applied on a substrate (copper foil: 12 µm thickness) and then dried at 100 to 200 °C for 5 to 15 minutes. Thereafter, for imidization, heat treatment was performed by maintaining the composition at 300 to 400 °C for 20 minutes or more. In this case, the molecular weight (Mw) of the polyimide precursor was 20,000 g/mol or more. Accordingly, a polyimide film with a final film thickness of 20 µm and copper clad laminates (FCCL) with the polyimide film and the copper foil were prepared.

**[Table 1]**

| | Diamine (mol) | | | | | | | | Acid anhydride (mol) |
|---|---|---|---|---|---|---|---|---|---|
| | PDA | m-TB | ODA | Diamine containing an ester group | | Diamine containing an alkyl group | | | |
| | | | | APAB | ABHQ | TrA (n=3) | TeA (n=4) | PA (n=36) | BPDA |
| Ex. 1 | 0.4 | 0.2 | 0.15 | 0.2 | - | - | - | 0.05 | 1 |
| Ex. 2 | 0.4 | 0.2 | 0.05 | 0.2 | - | - | - | 0.15 | 1 |
| Ex. 3 | 0.4 | 0.2 | 0.15 | 0.2 | - | - | 0.05 | | 1 |
| Ex. 4 | 0.4 | 0.2 | 0.15 | - | 0.2 | - | - | 0.05 | 1 |
| Ex. 5 | 0.4 | 0.2 | 0.35 | - | - | - | - | 0.05 | 1 |
| Comp. Ex. 1 | 0.4 | 0.2 | 0.4 | - | - | - | - | - | 1 |
| Comp. Ex. 2 | 0.4 | 0.2 | 0.35 | - | - | 0.05 | - | - | 1 |
| Comp. Ex. 3 | 0.4 | 0.2 | 0.2 | - | 0.2 | | - | - | 1 |
| Comp. Ex. 4 | 0.4 | 0.2 | 0.15 | - | 0.2 | 0.05 | - | - | 1 |

### [Comparative Example 1 to 4]

Polyimide films and copper clad laminates of Comparative Examples 1 to 4 were prepared in the same manner as in Examples 1 to 5, except that the compositions described in Table 1 were used.

### [Experimental example: Physical properties evaluation]

The physical properties of the polyimide films and the copper clad laminates prepared in Examples 1 to 5 and Comparative Examples 1 to 4 were evaluated by the following methods, and the results are shown in Table 2. Each physical property shown in Table 2 was measured using a polyimide film having a thickness of 12 µm.

### <physical property evaluation method>

### 1) viscosity measurement

After preparing a bubble-free polyimide precursor resin in a 100 mL sample bottle, the viscosity at room temperature was measured using a viscometer (Brookfield Corporation).

### 2) Dielectric loss (Df) measurement

A specimen having dimensions of 9 cm × 10 cm was prepared, etched, and dried at 110 °C for 1 hour. Thereafter, the specimen was stored in a constant temperature and humidity chamber at 23 °C and 50% relative humidity for 24 hours. Subsequently, a resonance cavity measurement at 10 GHz was performed in a moisture-absorbed state using a Network Analyzer (Keysight Technologies).

### 3) Adhesion measurement

Adhesion was measured according to the IPC-TM-650 2.4.9 specification. Specifically, a 1 mm pattern was formed on the copper foil surface, and the copper foil surface was pulled at an angle of 90° using a Shimadzu UTM (Universal Testing Machine) to measure the adhesion between the copper foil and the polyimide film.

### 4) Dimensional Stability Measurement after heating

Dimensional stability after heat treatment was measured according to IPC-TM-650 2.2.4. As shown in FIG. 1, a sample having dimensions of 30 cm (MD) × 27 cm (TD) was prepared, and holes were formed in the sample at positions corresponding to intervals of 25 cm in the MD direction and 23 cm in the TD direction. After etching the sample having the holes formed therein, the distance between the holes (initial distance) was measured. Subsequently, the sample was heat-treated at 150 °C for 30 minutes and stored at room temperature for 24 hours, after which the distance between the holes (final distance) was measured again, and the dimensional change rate was calculated according to Equation 1 below. In the measured dimensional change rate, a positive value indicates elongation, and a negative value indicates shrinkage. $\begin{matrix}M . D . = \frac{\frac{{\left(A-B\right)}_{F} - {\left(A-B\right)}_{I}}{{\left(A-B\right)}_{I}} + \frac{{\left(C-D\right)}_{F} - {\left(C-D\right)}_{I}}{{\left(C-D\right)}_{I}}}{2} \times 100 \\ T . D . = \frac{\frac{{\left(A-C\right)}_{F} - {\left(A-C\right)}_{I}}{{\left(A-C\right)}_{I}} + \frac{{\left(B-D\right)}_{F} - {\left(B-D\right)}_{I}}{{\left(B-D\right)}_{I}}}{2} \times 100\end{matrix}$

In Equation 1,
M.D. = dimensional change rate in the machine direction (MD),
T.D. = dimensional change rate in the transverse direction (TD),
(A-B)i = initial distance between points A and B,
(A-B)f = final distance between points A and B,
(A-C)i = initial distance between points A and C,
(A-C)f = final distance between points A and C,
(C-D)i = initial distance between points C and D,
(C-D)f = final distance between points C and D,
(B-D)i = initial distance between points B and D, and
(B-D)f = final distance between points B and D.

**[Table 2]**

| | viscosity | Dielectric loss | Adhesion strength | Dimensional Stability after heating |
|---|---|---|---|---|
| | (cPs) | (Df) | (kgf/cm) | (%) |
| Ex. 1 | 32,000 | 0.0028 | 1 | =-0.05 / -0.09 |
| Ex. 2 | 23,000 | 0.0022 | 0.95 | =-0.1 / -0.14 |
| Ex. 3 | 37,000 | 0.0035 | 1 | =-0.06 / -0.07 |
| Ex. 4 | 33,000 | 0.0027 | 1 | =-0.07 / -0.08 |
| Ex. 5 | 35,000 | 0.0033 | 1.05 | =-0.07 / -0.08 |
| Comp. Ex. 1 | 41,000 | 0.0075 | 1.05 | =-0.02 / -0.04 |
| Comp. Ex. 2 | 39,000 | 0.0071 | 1 | =-0.03 / -0.06 |
| Comp. Ex. 3 | 36,000 | 0.0044 | 1 | =-0.03 / -0.05 |
| Comp. Ex. 4 | 35,000 | 0.0043 | 0.95 | =-0.04 / -0.07 |

As shown in Table 2, it was found that Examples 1 to 4 including a diamine containing an alkyl group having a predetermined number of carbon atoms exhibited excellent processability due to an appropriate viscosity, while simultaneously achieving low dielectric loss, high adhesion strength, and excellent dimensional stability.

Specifically, Examples 1 to 5 using a diamine containing an alkyl group having 4 or more carbon atoms exhibited lower dielectric loss and lower viscosity than Comparative Examples 1 to 4, which did not include the diamine or included a diamine containing an alkyl group having 3 carbon atoms. In particular, as the number of carbon atoms in the diamine increased, the dielectric loss characteristics of the polyimide film were further improved. In addition, it was confirmed that superior dimensional stability after heat treatment was achieved when a diamine containing an alkyl group having 4 or more carbon atoms and a diamine containing an ester group were used in combination.

## Claims

1. A polyamic acid composition comprising:
at least one diamine;
at least one acid anhydride; and
an organic solvent;
wherein the diamine further comprises a diamine containing an alkyl group having 4 or more carbon atoms in a main chain or a side chain.

2. The polyamic acid composition of claim 1, wherein the alkyl group is a linear aliphatic alkyl group having 4 to 40 carbon atoms.

3. The polyamic acid composition of claim 1, wherein the diamine containing an alkyl group having 4 or more carbon atoms is selected from compounds represented by the following Chemical Formulas 1 to 3: 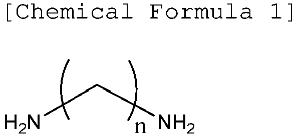 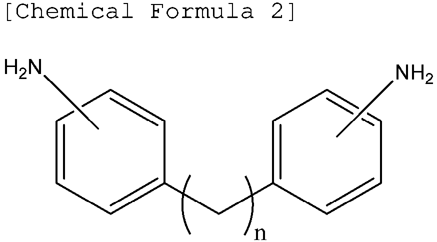 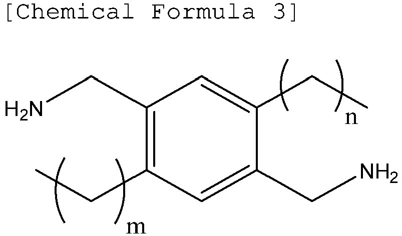 wherein, in Chemical Formulas 1 to 3,
n and m are the same as or different from each other and are each independently an integer of 4 to 40.

4. The polyamic acid composition of claim 1, wherein the diamine containing the alkyl group having 4 or more carbon atoms is included in an amount of more than 0 mol % and 20 mol % or less, based on 100 mol % of the total amount of the diamine.

5. The polyamic acid composition of claim 1, wherein the diamine further comprises a diamine containing one or more ester groups and an aromatic ring in a main chain.

6. The polyamic acid composition of claim 5, wherein the diamine containing the ester group and the aromatic ring is included in an amount of 5 to 30 mol %, based on 100 mol % of the total amount of the diamine.

7. The polyamic acid composition of claim 5, wherein a mixing ratio of the diamine containing the alkyl group having 4 or more carbon atoms and the diamine containing the ester group and the aromatic ring is in a range of 1:1.1 to 1:5 mol %.

8. The polyamic acid composition of claim 1, wherein the at least one diamine comprises at least one selected from the group consisting of a fluorinated aromatic diamine; a sulfone-based aromatic diamine; a hydroxy-based aromatic diamine; an ether-based aromatic diamine; a non-fluorinated aromatic diamine; and an alicyclic diamine.

9. The polyamic acid composition of claim 1, wherein the at least one acid anhydride comprises at least one selected from the group consisting of a fluorinated aromatic acid anhydride, a non-fluorinated aromatic acid anhydride, a sulfone-based aromatic acid anhydride, and an alicyclic acid anhydride.

10. The polyamic acid composition of claim 1, further comprising an inorganic filler.

11. The polyamic acid composition of claim 1, wherein the polyamic acid composition has a viscosity of 10,000 to 50,000 cps at 25° C.

12. A polyimide film formed by imidizing the polyamic acid composition according to any one of claims 1 to 11.

13. The polyimide film of claim 12, wherein the polyimide film has a weight average molecular weight (Mw) of 20,000 g/mol to 100,000 g/mol.

14. A metal clad laminate comprising:
at least one metal layer; and
a polyimide insulating layer formed on one surface of the metal layer or between the metal layers, and formed by imidizing the polyamic acid composition according to any one of claims 1 to 11.

15. The metal clad laminate of claim 14, wherein the polyimide insulating layer is formed by applying, drying, and imidizing the polyamic acid composition on the metal layer, and the metal clad laminate does not comprise a thermoplastic polyimide or an adhesive.

16. The metal clad laminate of claim 14, wherein the metal layer is selected from copper, aluminum, iron, silver, palladium, nickel, chromium, molybdenum, tungsten, or an alloy thereof.

17. The metal clad laminate of claim 14, wherein the polyimide insulating layer has a thickness of 1 to 50 µm.

18. The metal clad laminate of claim 14, wherein the metal clad laminate has a dielectric loss (Df) of 0.007 or less, measured at a frequency of 10 GHz or more and 28 GHz or less;
an adhesive strength of the polyimide insulating layer to the metal layer according to IPC-TM-650 2.4.9 of 0.7 kgf/cm or more;
a dimensional change rate in the MD direction according to IPC-TM-650 2.2.4 of ±0.2% or less; and
a dimensional change rate in the TD direction according to IPC-TM-650 2.2.4 of ±0.2% or less.

19. A printed circuit board comprising the polyimide film of claim 12.
